(19) Europäisches Patentamt
European Patent Office
Office européen des brevets

(11) **EP 3 928 389 B1**

(12) **EUROPEAN PATENT SPECIFICATION**

(45) Date of publication and mention
of the grant of the patent:
**03.09.2025 Bulletin 2025/36**

(21) Application number: **20777912.5**

(22) Date of filing: **26.03.2020**

(51) International Patent Classification (IPC):
*H01S 5/02* (2006.01)   *G02B 6/42* (2006.01)
*H01S 5/02325* (2021.01)   *H01S 5/40* (2006.01)
*H01S 5/02216* (2021.01)   *H01S 5/02251* (2021.01)

(52) Cooperative Patent Classification (CPC):
**H01S 5/4012; G02B 6/4206; H01S 5/02251;**
**H01S 5/02325; H01S 5/4031; H01S 5/405;**
H01S 5/02216

(86) International application number:
**PCT/US2020/024809**

(87) International publication number:
**WO 2020/198406 (01.10.2020 Gazette 2020/40)**

(54) **FIBER-COUPLED DIODE LASER MODULE AND METHOD OF ITS ASSEMBLING**

FASERGEKOPPELTES DIODENLASERMODUL UND VERFAHREN ZU DESSEN ZUSAMMENBAU

MODULE LASER À DIODE FIBRÉ ET SON PROCÉDÉ D'ASSEMBLAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.03.2019 US 201962824774 P**

(43) Date of publication of application:
**29.12.2021 Bulletin 2021/52**

(73) Proprietor: **IPG Photonics Corporation
Oxford, MA 01540 (US)**

(72) Inventors:
• **CHUYANOV, Vadim
Oxford, MA 01540 (US)**

• **MIFTAKHUTDINOV, Dmitriy
Oxford, MA 01540 (US)**

(74) Representative: **Kobiako von Gamm, Iouri
Kobiako-von Gamm
Patent- und Rechtsanwaltskanzlei
PartG mbB
Bruckmannstraße 13
80638 München (DE)**

(56) References cited:
WO-A1-2018/142657   US-A1- 2007 195 850
US-A1- 2009 323 752   US-A1- 2015 003 484
US-A1- 2016 079 728   US-A1- 2016 246 022
US-A1- 2017 315 311   US-B2- 7 764 723

**Description**

BACKGROUND OF THE DISCLOSURE

Field o the Disclosure

The disclosure relates to fiber coupled (pigtailed) multi-emitter multimode (MEMM) diode laser modules. In particular, disclosed is an improved light coupling arrangement including a pigtailed MEMM diode laser module configured with at least one lens which is spaced from the fiber's core at a distance exceeding the focal length of the lens. The disclosure further relates to a method of assembling the disclosed module.

Prior Art

High efficiency, high power levels, and high spectral and directional brightness are attractive characteristics of pigtailed diode laser modules used in in many areas, such as material processing, offset printing, medical treatment, pumping of solid state lasers. Improving all of these characteristics is important practically for all applications. It is particularly critical for laser diode pumped fiber lasers. Although the fiber laser powers continuously increase, high power fiber lasers still underperform, at least partially, due to the coupling losses of pump light. The disclosed coupling arrangement decreases the losses to about 2 - 3%. Such a decrease is significant considering that even the loss of a fraction of percent is considered a major success.

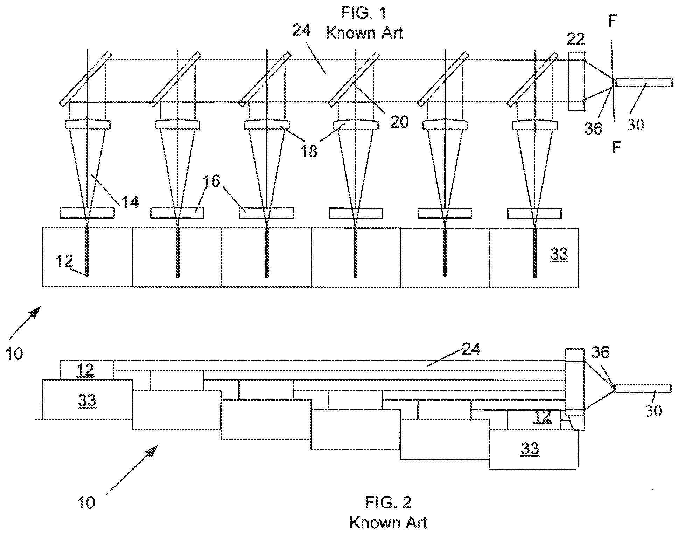

A typical prior-art high-power multi-emitter multimode-fiber-coupled diode laser module 10 is illustrated in FIGs. 1 and 2 and disclosed, for example, in U.S. Pat. No. 7,764,723 to Ovtchinnikov et al. ("the '723 patent"). At the most basic level, diode laser emitters or chips 12 are supported by respective mounts 33 and output astigmatic beams 14 along a light path. In FIG. 1, each individual chip 12 in the array is stacked one upon another. Various optics 16, 18, 20 and 22 collimate and shape the beam 14 of each emitter such that all light beams 14 are combined into a single astigmatic combined beam 24. The combined beam 24 is guided towards a fiber 30, which has a receiving core end located in the focal plane F - F of objective lens 22, and focused on the core end.

Each broad-area MM chip 12 emits a non-circular beam 14 in the first direction. Due to a thin-slab geometry of diode lasers, their radiation, propagating along Z-axis, has a highly asymmetric lateral distribution of optical power density and divergence along X- and Y-axes. Each beam 14 is broad in its slow-axis and narrow in its fast-axis. Accordingly, the shown schematic has, as a rule, fast-axis collimator (FAC) 16 and slow-axis collimator (SAC) 18 making beam 14 parallel in both fast and slow axes. Multiple beams 14 are further combined by a set of mirrors 20 in combined beam 24 in which multiple beams 14 propagate in a second direction parallel to one another in the vertical plane.

As a result, combined beam 24 collimated in both axes is incident on and filling a region of objective lens 22 such that beam spot 36 is coupled into core end 31 of fiber 30 located in focal plane F - F of objective lens (OL) 22. The '723 patent teaches using as large a beam spot 36 as possible. As a result, the divergence of the beam in the near field is minimally possible, and the brightness of the beam, illuminating output fiber 30, is relatively good.

However, the above holds true only to a point-like light source. The chip 12 has multiple points emitting respective rays. Thus, in contrast to the point-like source, the chip is rather elongated and further referred to as an extended light source or chip. The beam 24 from the extended light source is not ideally collimated at least in the slow axis. As a consequence, when such a nonparallel beam is focused in the slow axis in focal plane F - F by objective lens, OL, 22, its beam spot may be excessively large for lossless or near lossless coupling into the fiber's core end, as explained below.

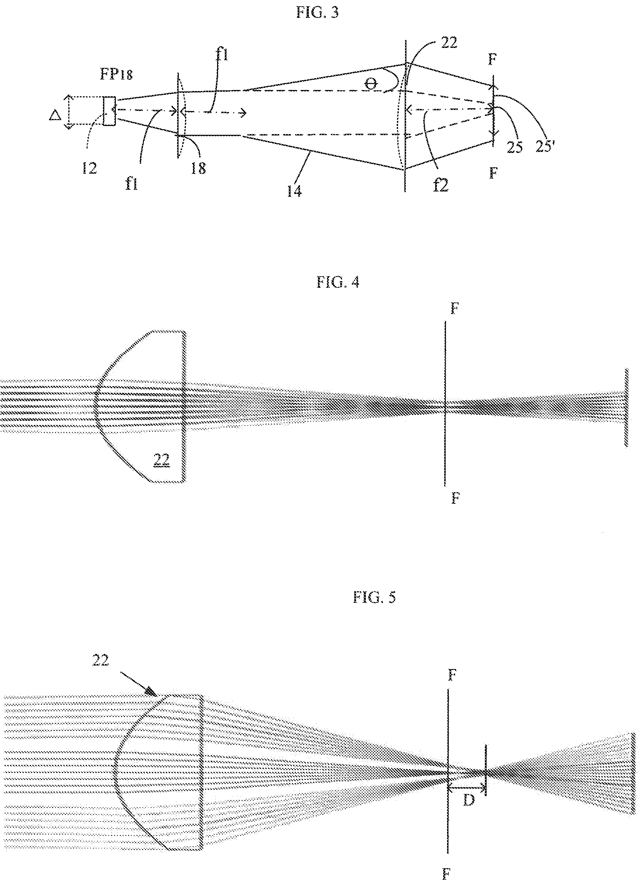

FIG. 3 illustrates a ray diagram for individual extended light source 12. The chip 12 is located in a focal plane FP18 of SAC 18 having a relatively short focal length, such as less than 6 mm. If light was emitted from a point light source, it would be collimated in the slow axis (SA) by SAC 18 and propagate as an ideal parallel beam 14, shown in dashed lines, over a distance to OL 22. As a result, the point light source would have both a sharp image in focal plane F - F of OL 22 and a minimal beam spot or waist 25 formed in focal plane F - F. The focal plane is determined as $\frac{f2}{f1}\triangle$ , wherein f2 and f1 are respective focal lengths of lenses 22 and 18 and $\triangle$ is the size of the extended source. The diode laser 12 however has an array of multiple light emitting points causing the single beam 14 to diverge at an angle $\Theta = \frac{\triangle}{f1}$, wherein $\Theta = \triangle/2f_1$, beginning approximately from a rear focus of OL 22. As a distance between lenses 18 and 22 increases, the beam progressively expands in the slow axis and finally impinges upon objective lens 22, as shown in solid lines. As a consequence, waist 25' of the beam in focal plane FP22 is considerably larger than the smallest beam spot 25 of the ideally collimated beam. The same logic should be applied to combined beam 24 which includes multiple beams 14 diverging in the slow axis and emitted by respective chips 12 of module 10 of FIGs. 1 and 2. Of course, for beam 24 to appreciably diverge, the distance between SAC 18 and OL 22 should be significant.

FIGs. 4 and 5 discussed in conjunction with FIG. 3 illustrate slow axis (SA) OL 22 displaced off SAC 18 at respective first and second distances, with the first distance (FIG. 4) being shorter than that the second one (FIG. 5.) In FIG. 4 like in FIG. 3, rays R1 - R3 (or spatial modes) from respective three light emitting spots of extended diode laser 12 are substantially parallel to one another upon impinging SAOL 22 since a distance between SAOL 22 and the SAC is small. The OL 22 focuses the incident beams in its focal plane F - F in which respective waists (cross-sections) are the smallest. As a consequence, the waist of the combined focused beam is such that the focused beam is coupled into core end without substantial losses, if at all. Thus, the image of the extended light source is the sharpest in focal plane F - F with the waist of the combined beam being the smallest in the same plane.

In contrast, FIG. 5 illustrates a configuration in which the distance between the SAC and SAOL 22 is long enough for the same three - red, blue and green - rays or spatial modes to significantly diverge and impinge a large area of SAOL 22. While the image of the extended source is still the sharpest in the focal plane F - F, the spatial modes however continue to converge beyond focal plane F - F. As a consequence, the smallest cross-section of the combined beam is formed beyond focal plane F - F at a distance D. Mounting an output fiber with its core end in the focal plane F - F results in the loss of light since the core diameter is smaller than the cross-section of the focused beam of FIG. 5 in the focal plane. The light power loss results in poor throughput and overheated module components and damaged output fiber.

A need therefore exists for an improved configuration of pigtailed MEMM diode laser module.

A further need exists for a method of manufacturing the disclosed MEMM diode laser module.

United States Patent Application Publication No. US 2015/003484 A1 describes an arrangement of laser diode emitters which emit broad-area light beams in a beam direction. In cross-section, each beam is broad in its slow axis and narrow in its fast axis. Groups of downstream optical components collimate, shape, stack and direct the beams along a light path towards a beam spot (which may be fiber-coupled). After collimating, stacking and directing, the beams are Fourier transformed in the fast-axis through a lens feature having a fast-axis focal length less than about 3 millimeters. In some embodiments, the fast-axis focal length is between about 0.1 and 2.0 millimeters. Astigmatism may be introduced between the fast axis and the slow axis in the beams upstream of the lens feature and in accordance with the fast axis focal length of the lens feature.

United States Patent Application Publication No. US 2016/079728 A1 discloses a semiconductor laser module including a semiconductor laser element emitting a laser light; an optical fiber, into which the laser light emitted from the semiconductor laser element is incident, guiding the laser light; and an optical-fiber-holding unit having a fixing agent and holding the optical fiber, the fixing agent being for fixing the optical fiber. The fixing agent is provided at an area in which a power of a leakage light of the laser light having been incident into the optical fiber and then emitted to outside the optical fiber is low.

## SUMMARY OF THE DISCLOSURE

The disclosed MEMM pigtailed diode laser module and method of its manufacturing differ from the known prior art by mounting a slow axis objective lens (SAOL) such that the receiving end of the output fiber is spaced from the lens at a distance exceeding the focal length of SAOL, i.e., beyond the lens's focal plane. This seemingly a counterintuitive configuration would be perfectly logical considering that the disclosure is not concerned with the image quality, which is the highest in the focal plane, but with the collection of light, i.e., brightness. In the disclosed configuration, multiple extended light sources, such as diode lasers, are located in the focal plane of respective SACs which are spaced at a distance from the SAOL sufficient for a combined beam to significantly diverge. To prevent clipping of the focused beam by the fiber's core, which is smaller than the cross-section of the focused beam in the focal plane of the SAOL, the fiber is located beyond the focal plane. The distance between the SAOL and fiber core is increased such that a cross section of the focused beam is small enough to provide substantially lossless coupling of light into the core.

In accordance to a first aspect, the invention provides a pigtailed diode laser module in accordance with claim 1. According to a second aspect, the invention provides a method of manufacturing a pigtailed diode laser module in accordance with claim 4. Further aspects of the invention are set forth in the dependent claims, the drawings and the following description of embodiments. The pigtailed laser module is configured with a case housing at least one row of MM diode lasers which emit respective parallel beams in a first direction. Each beam is collimated in fast and slow axes by a pair of respective FACs and SACs with the SACs being spaced downstream from respective FACs in the first direction. The disclosed module further includes multiple beam reflectors or mirrors guiding respective collimated beams, which constitute a combined beam, in a second direction, wherein the first and second directions are transverse to one another. At least one SAOL is located downstream from the last downstream reflector and operative to focus the combined beam at least in the slow axis in its focal plane. The module further has a fiber the upstream end of which is aligned with the SAOL in the second direction. The upstream end of the fiber is mounted in a plane in which the combined beam has the smallest cross-section. This plane is located beyond the focal plane.

Due to different distances of respective light sources from the SAOL, smallest cross-sections of respective beam components in the combined beam are located at different distances beyond the focal plane. The diode laser nearest to the SAOL outputs a beam component having a minimal cross-section at the shortest distance beyond the focal plane. The minimal cross-section of the beam component emitted by the diode laser farthest from the SAOL in the upstream direction is spaced downstream from the focal plane at a distance greater than that of the nearest diode laser.

Accordingly, the disclosed method further comprises a step of determining minimal cross-sections of respective beams of the nearest and farthest diode lasers downstream from the SAOL, and then determining a distance between them. Finally, the disclosed method comprises the step of displacing the SAOL upstream from its original location at the determined distance to provide substantially lossless coupling of the combined beam into the core end.

BRIEF DESCRIPTION OF THE DRAWINGS

The above and other aspects and features will become more readily apparent from the following drawings, in which:

> FIGs. 1 and 2 illustrate a pigtailed MEMM diode laser module of the known prior art.
> FIG. 3 is a ray diagram associated with an individual extended light source;
> FIGs. 4 and 5 are respective ray diagrams illustrating the operation of the individual extended diode laser at first and second distances between a SAC and SAOL, wherein the second distance is greater than the first one;
> FIGs. 6 and 7 illustrate respective optical schematics of the disclosed pigtailed MEMM diode laser module; and
> FIG. 8 illustrates the desired locations of minimal cross-sections of respective beams depending from distances at which the chips are spaced from the SAOL in FIGs. 6 and 7.
> FIGs. 9 and 10 illustrate respective perspective views of optical schematics of respective FIGs. 6 and 7.

SPECIFIC DESCRIPTION

In the figures, each identical or nearly identical component that is illustrated in various figures is represented by a like numeral. For purposes of clarity, not every component may be labeled in every figure.

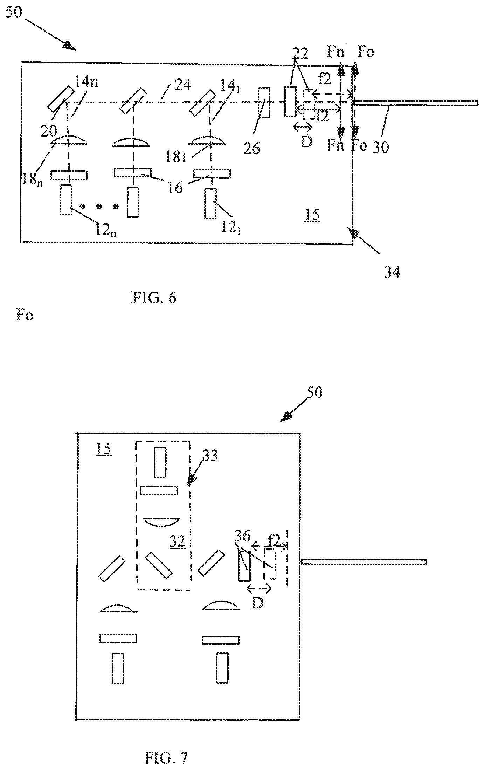

Referring to FIGs. 6 and 7, a laser module 50 includes a plurality of spaced diode lasers or chips 12 ($12_1 ... 12_n$) outputting respective parallel beams 14 in the first direction. The chips 12 are each associated with a beam-shaping optic including FAC 16, SAC 18 and mirror 20.

Each chip 12 is aligned with designated FAC 16, SAC 18 and mirror 20 in the first direction and together these components constitute a group 32 (FIG. 7). The beams 14 each are collimated first in the fast axis by FAC 16 and then in the slow axis by SAC 18. In the fast axis, beam 14 is SM while in the slow axis this beam includes multiple spatial modes (MM).

The beams 14 are further redirected by respective mirrors 20 in a second direction, which is transverse to the first direction, and form a combined beam 24. The groups 32 are enclosed in case 34 having a bottom 15 which is made of heat-dissipating material and have respective chips 12 each coupled to mount 33 also made from heat dissipating material. The groups 32 (FIG. 7) may be mounted on a common mount 33 or on respective individual mounts 33 (FIG. 2) which are in contact with bottom 15. The architectures of module 50 illustrated in respective FIGs. 6 and 7 are well known from USPs 7,764,723 and 8,711,894.

Specifically, FIG. 6 illustrates chips $12_1$ - $12n$ mounted in a row. Typically, module 50 is configured with two rows of chips 12 of FIG. 7 which are mounted on respective opposite sides of combined beam 24 such that groups 32 of one row are not aligned with respective groups 32 of the other row in the first direction. The output fiber 30 is mounted in a ferrule (not shown) and aligned with fast axis objective lens 26 (FAOL) and SAOL 22 in the second direction.

It should be noted that combined beam 24 is astigmatic in which smallest cross-sections or waists in respective slow and fast axes are spaced from one another. Astigmatism may be corrected by installing FAOL 26 upstream from SAOL 22, as shown in FIG. 6 such that respective focal planes of these lenses located in the same plane. Alternatively, it is possible to use, among others, a single spherical, aspherical, cylindrical lens 36, as shown in FIG. 7. Each of the schematics of FIGs. 6 and 7 may be configured with multiple objective lenses or a single one as explained in somewhat greater detail below. However, beam 24 may remain astigmatic since the waist along the fast axis is very deep (Raleigh parameter is ~1 mm.) Thus as long as mirrors 20 focus combined beam 24 on the fiber's core, the astigmatism may not be critical.

The distance between any of SACs 18 and SAOL 22 in both FIGs. 6 and 7 increases with the increased number of chips addressing the demands for higher output powers. The experiments show that generally when SAC 18 is configured with a focal length exceeding, for example, about 6 mm, the beam may significantly diverge in the slow axis.

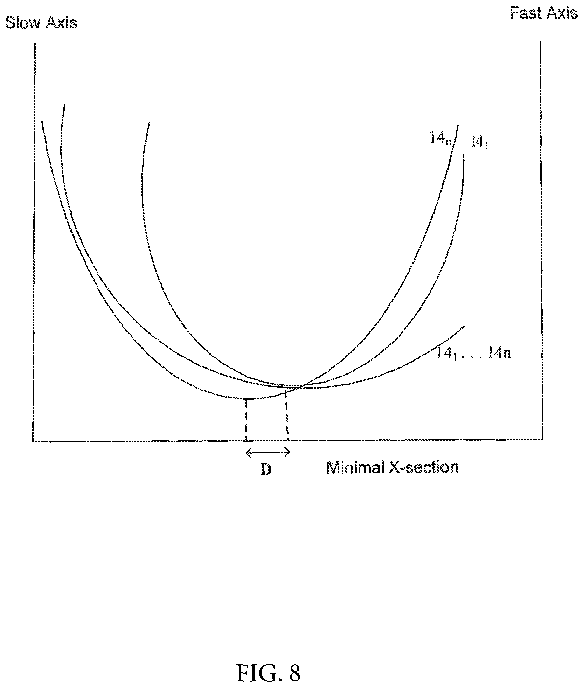

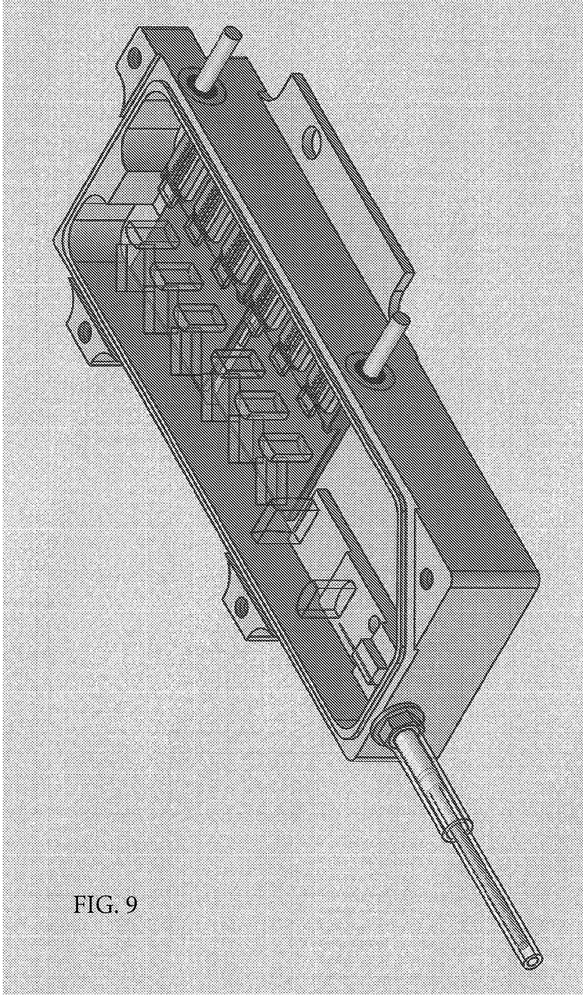

In accordance with one of the aspects of the disclosure, SAOL 22 is displaced upstream from its original position, in which the SAOL, focal length f2 and original focal plane Fo - Fo all each are shown in dash lines, to its new optimal position, in which SAOL 22 along with focal length f2 and new focal plane Fn - Fn are shown in solid lines. A distance D between the original and optimal positions ranges between about 50 and 500 $\mu$m and may be determined in accordance with the disclosed method discussed below in reference to FIG. 8. The output fiber 30 remains intact with the receiving end thereof lying in the original focal plane Fo - Fo. The focal plane of FAOL 26 coincides with the original focal plane Fo - Fo of SAOL 22 before the latter is shifted upstream. The desired distance at which SAOL 22 is displaced upstream from its original position is determined so that the smallest cross-section of the combined beam in the slow axis also lies in the original focal plane Fo - Fo. In other words, SAOL 22 and the receiving core end are spaced at a distance equal to the focal length of the SAOL and a newly determined distance D, as explained hereinbelow. The schematic of FIG. 6 can also be seen in FIG. 9.

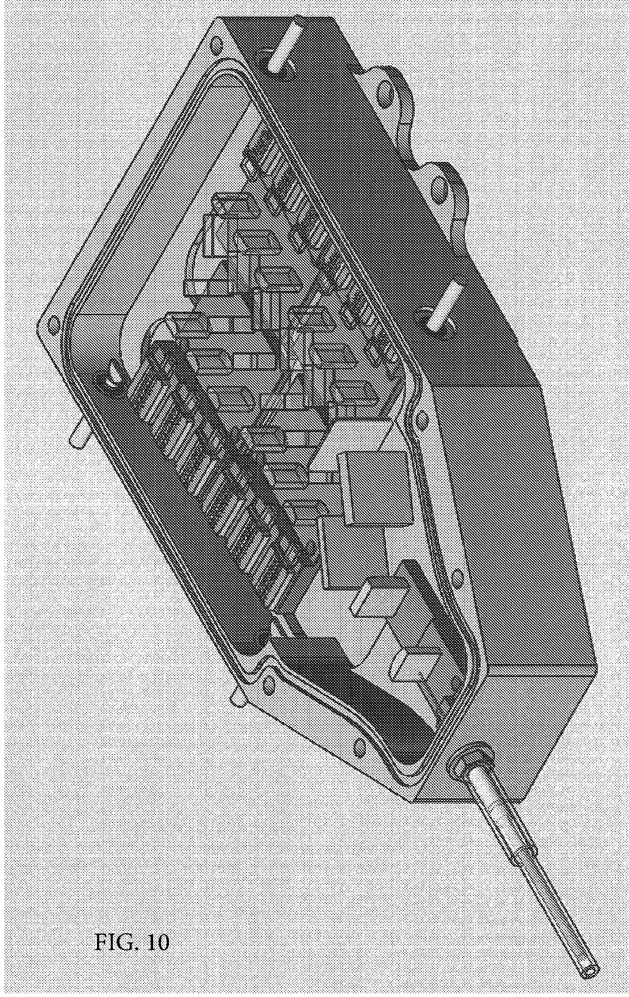

Referring specifically to FIG. 7, diode module 50 has an additional row of chips 12. As mentioned above, only one lens 36 functioning simultaneously as FAOL and SAOL is utilized in the shown configuration. According to the above-discussed salient feature of the disclosure, lens 36 is shifted upstream from its original position shown in dash lines and including the receiving end of fiber 30, to an optimal position at the determined distance D for the reasons explained above. The optical schematic of FIG. 7 is also shown in FIG. 10.

Referring to FIGs. 5- 7, beams $14_1$ ... $14_n$ are output by respective chips $12_1$ ... $12_n$ and propagate over different optical paths before impinging upon SAOL 22. Due to different optical paths, the region of SAOL 22 impinged by multiple beams 14 varies. The region with the smallest area is impinged by beam $14_1$, which propagates over the shortest optical path since chip $12_1$ is the closest to SAOL 22 or 36, whereas the largest area is covered by beam 14n which is emitted from chip $12_n$ most distant from the SAOL 22. As a consequence, beams $14_1$ - 14n are "focused" in slow axis at respective different distances downstream from focal plane F - F corresponding to the original position of SAOL 22 and including the receiving end of fiber 30. The distance between the small beam cross-sections of respective beams $14_1$ and $14_n$ emitted by first and last chips of module 10 determines the distance D at which SAOL 22 is shifted upstream from its original position. Alternatively, distance D may be determined as the mean of all distances of respective smallest cross-sections of beams $14_1$ ... $14_n$.

FIG. 8 considered in light of FIGs. 5 - 7 helps explain the location adjustment of the SAOL in the context of the present disclosure. As one of ordinary skilled in the semiconductor arts readily understands, in mass production once a sample, such as a MEMM diode laser module, is tuned up, subsequent modules are each easily adjusted in accordance with data obtained during the tuning of the sample. Thus, the determined distance D, at which the SAOL is shifted upstream from its original position is once determined, is subsequently used in all other modules.

Accordingly, selectively turning either each of chips 12 in the tested module or just two chips - the closest to and most distant from the SAOL - it is possible to determine minimal cross-sections of respective beams incident on fiber 30. As can be seen in FIG.8, curves 1 through 6 correspond to respective beams $14_1$ ... $14_n$ of FIGs. 5 - 7. The smallest cross-section of each beam corresponds to a bottom region of the associated curve. Thus, curve 1 corresponding to beam $14_1$ from chip $12_1$,

which is located at the shortest distance upstream from the SAOL, has its smallest cross-section downstream from focal plane F - F at the shortest a distance. The beam 14n emitted from distant chip 12n corresponds to curve 6 and has its smallest cross-section at a second distance greater than that one of beam $14_1$. The distance D between the smallest cross-sections of respective beams $14_1$ and $14_n$ relative to the SAOL is the desired uniform distance for all subsequently tunable modules at which the SAOL is shifted upstream from its original position. The curve 7 illustrates the behavior of all beams after combined beam is focused in FAOL 36. As can be seen, SM beams $14_1$ ... $14_n$ have respective beam spots in fast axis lying in the same plane as the receiving core end of output fiber 30. In other words, in the fast axis beams 14 each are focused in focal plane F - F of SAOL 22 before the latter is shifted at distance D to its optimal position.

Referring to the configuration with single lens 36 of FIG. 7, care has to be taken not only of the lens adjustment in the slow axis, but also in the fast axis. The displacement of lens 36 from its original position to the optimal position in the slow axis at distance D detrimentally affects the beam spot of the combined beam in the fast axis because when lens 36 is in its original position, the smallest beam spot in the fast axis is located in original focal plane F - F. However, the angular adjustment of mirror or mirrors 20 can effectively compensate for the shift of lens 36. The mirrors 20 can be angularly adjusted such that beams $14_1$ ... $14_n$, incident on the lens 36, open up at a greater angle and thus could be focused in focal plane F - F of lens 36 when it is located in its original position. The angular position of the mirrors, like distance D, can be used for adjusting subsequent diode laser modules in mass production.

As one of ordinary skill readily realizes the above and further disclosed features of the inventive module and method can be used in any possible situation and all together. Certain obvious modifications of the disclosed module can be easily surmised by one of ordinary skill in the laser arts without departing from the scope of the invention as defined in the appending claims. For example, the disclosed chips may be mounted so that respective output beams propagate in the same direction along the entire path until the combined beam is collimated in a slow axis and coupled into the fiber. This can be realized by arranging collimating and beam guiding optics in a configuration apparent to one of ordinary skill. Thus although shown and disclosed is what is believed to be the most practical and preferred embodiments, it is apparent that departures from the disclosed configurations and methods will suggest themselves to those skilled in the art and may be used without departing from the scope of the invention as defined in the appending claims.

## Claims

1. A pigtailed diode laser module (50), comprising:

    a case (34) housing spaced multimode, MM, chips (12) outputting respective parallel output beams (14) along a path;
    an optical system configured to collimate the parallel output beams (14) into collimated beams in respective slow axes, wherein the collimated beams define a combined beam (24) which diverges along the path
    wherein the optical system includes:

    a plurality of slow-axis collimators, SAC, (18) each located between and optically coupled to the MM chip (12) and one focusing lens configured to collimate the output beam (14) in the slow axis; and
    a plurality of fast-axis collimators, FAC, (16) coupled between respective MM chips (12) and SACs (18), the MM chips (12) being arranged in at least one row and emitting the respective output beams (14) in a first direction;

    at least one focusing lens (22) for focusing the combined beam (24) in a focal plane thereof; and
    an output fiber (30) coupled to the case (34) and having a core end downstream from the focal plane,
    wherein the combined beam (24), coupled into the core end, has a cross-section smaller than that of the combined beam (24) in the focal plane, **characterized in that**
    the core end is spaced downstream from the focal plane of the one focusing lens (22) at a distance corresponding to a difference between distances of respective smallest cross-sections of output beams (14), which are emitted by respective first and last MM chips (12), said respective smallest cross-sections being located downstream from the one focusing lens (22), with the first MM chip (12) being closest to the focusing lens (22), and the last MM chip (12) being farthest from the focusing lens (22); or **in that**
    the core end is spaced downstream from the focal plane of the one focusing lens (22) at a distance corresponding to a mean value of distances between the one focusing lens (22) and respective smallest cross-sections of output beams (14) which are located downstream from the one focusing lens, with the MM chips (12) being spaced from the one focusing lens (22) at respective distances which are different from one another.

2. The pigtailed diode laser module (50) of claim 1, wherein the optical system further includes a plurality of angularly adjustable mirrors (20) each located between the SAC (18) and the one focusing lens (22) and deflecting the collimated output beam in a second direction transverse to the first direction, the focusing lens (22) being configured to focus the combined beam (24) in both fast and slow axes.

3. The pigtailed diode laser module (50) of claim 1, further comprising
    at least one second focusing lens spaced upstream from the one focusing lens (22) and configured to focus the combined beam (24) in the fast axis.

4. A method of manufacturing a pigtailed diode laser module (50), comprising:

    energizing a plurality of MM chips (12), thereby outputting respective parallel beams (14);
    collimating the parallel output beams (14) each in a slow axis with a slow axis collimator, SAC, optically coupled to the MM chip (12) and located downstream therefrom, wherein the collimated beams propagate along a path and define a combined beam (24) diverging along the path;
    focusing the diverging combined beam (24) in a focal plane of a one focusing lens; locating a beam receiving core end of an output fiber (30) in the focal plane;
    and
    displacing the one focusing lens away from the beam receiving core end of the output fiber (30) by a predetermined distance such that the combined beam (24) is coupled into the receiving core end,
    wherein the focused combined beam (24) has a cross-section at an entrance of the receiving core end smaller than the cross section of the combined beam (24) in the focal plane, **characterized in that** the predetermined distance is determined by:
    locating smallest spaced cross-sections of respective two output beams (14) downstream from the one focusing lens (22), the two output beams (14) being emitted by respective MM chips (12) with one of the MM chips (12) being closest to and the other MM chip (12) being farthest from the one focusing lens (22);
    determining a distance between the located smallest cross-sections; and
    choosing as predetermined distance the distance determined in the previous step, or by:

    locating smallest cross-sections of respective output beams (14) downstream from the one focusing lens (22);
    determining a distance as a mean value of distances between the one focusing lens and respective located cross-sections; and choosing as predetermined distance the distance determined in the previous step.

5. The method of claim 4, wherein the one focusing lens focuses the diverging combined beam (24) in a slow-axis.

6. The method of claim 5, further comprising:

collimating output beams (14) each in a fast axis by a fast axis collimator, FAC, (16) located upstream from the SAC (18); and focusing the diverging combined beam (24) in the fast axis by the one focusing lens.

7. The method of claim 6, further comprising

focusing the diverging combined beam (24) in the fast axis by a second focusing lens located between the MM chips (12) and the one focusing lens ; selectively adjusting an angular position of selective mirrors located between the second focusing lens and respective SACs (18) to adjust a focal plane of the one focusing lens (22) in a fast axis of the combined beam (24) to be coplanar with the upstream core end of the output fiber (30).

8. The method of claim 4, further comprising:

collimating the output beams (14) in respective fast axes by a plurality of FACs (16) each located upstream from the SAC (18); and focusing the diverging combined beam (24) in the fast axis by a second focusing lens located between the MM chips (12) and the one focusing lens.

**Patentansprüche**

1. Diodenlasermodul (50) mit Anschlussfaser, das umfasst:

ein Gehäuse (34), das beabstandete Mehrmodenchips, MM-Chips, (12), die jeweils entlang eines Wegs parallele Ausgangsstrahlen (14) ausgeben, aufnimmt; ein optisches System, das dafür konfiguriert ist, die parallelen Ausgangsstrahlen (14) zu kollimierten Strahlen in jeweiligen langsamen Achsen zu kollimieren, wobei die kollimierten Strahlen einen kombinierten Strahl (24) definieren, der entlang des Wegs divergiert, wobei das optische System enthält:

mehrere Kollimatoren der langsamen Achse, SAC, (18), die sich jeweils zwischen dem MM-Chip (12) und einer Sammellinse, die zum Kollimieren des Ausgangsstrahls (14) in der langsamen Achse konfiguriert ist, befinden und optisch mit ihnen gekoppelt sind; und mehrere Kollimatoren der schnellen Achse, FAC, (16), die zwischen jeweiligen MM-Chips (12) und SACs (18) gekoppelt sind, wobei die MM-Chips (12) in wenigstens einer Reihe angeordnet sind und die jeweiligen Ausgangsstrahlen (14) in einer ersten Richtung emittieren; wenigstens eine Sammellinse (22) zum Fokussieren des kombinierten Strahls (24) in eine Brennebene davon; und eine Ausgangsfaser (30), die mit dem Gehäuse (34) gekoppelt ist und auslassseitig der Brennebene ein Kernende aufweist, wobei der kombinierte Strahl (24), der in das Kernende gekoppelt wird, einen kleineren Querschnitt als der kombinierte Strahl (24) in der Brennebene aufweist, **dadurch gekennzeichnet, dass** das Kernende in einem Abstand, der einer Differenz zwischen Abständen jeweils kleinster Querschnitte der Ausgangsstrahlen (14), die durch den ersten bzw. den letzten MM-Chip (12) emittiert werden, entspricht, von der Brennebene der einen Sammellinse (22) auslassseitig beabstandet ist, wobei sich die jeweils kleinsten Querschnitte auslassseitig der einen Sammellinse (22) befinden, wobei der erste MM-Chip (12) der Sammellinse (22) am nächsten ist und der letzte MM-Chip (12) von der Sammellinse (22) am fernsten ist; oder dadurch, dass das Kernende in einem Abstand, der einem Mittelwert von Abständen zwischen der einen Sammellinse (22) und jeweils kleinsten Querschnitten der Ausgangsstrahlen (14), die sich auslassseitig der einen Sammellinse befinden, entspricht, von der Brennebene der einen Sammellinse (22) auslassseitig beabstandet ist, wobei die MM-Chips (12) in jeweils voneinander verschiedenen Abständen von der einen Sammellinse (22) beabstandet sind.

2. Diodenlasermodul (50) mit Anschlussfaser nach Anspruch 1, wobei das optische System ferner mehrere in Winkelrichtung einstellbare Spiegel (20) enthält, die sich jeweils zwischen dem SAC (18) und der einen Sammellinse (22) befinden und den kollimierten Ausgangsstrahl in einer zweiten Richtung quer zu der ersten Richtung ablenken, wobei die Sammellinse (22) dafür konfiguriert ist, den kombinierten Strahl (24) sowohl in der schnellen als auch in der langsamen Achse zu fokussieren.

3. Diodenlasermodul (50) mit Anschlussfaser nach Anspruch 1, das ferner umfasst:
wenigstens eine zweite Sammellinse, die einlassseitig von der einen Sammellinse (22) beabstandet ist und dafür konfiguriert ist, den kombinierten Strahl (24) in der schnellen Achse zu fokussieren.

4. Verfahren zum Herstellen eines Diodenlasermoduls (50) mit Anschlussfaser, wobei das Verfahren umfasst:

Anlegen einer Spannung an mehrere MM-Chips (12), dadurch Ausgeben jeweils paralleler Strahlen (14);
Kollimieren der parallelen Ausgangsstrahlen (14) jeweils in einer langsamen Achse mit einem Kollimator der langsamen Achse, SAC, der mit dem MM-Chip (12) optisch gekoppelt ist und sich auslassseitig davon befindet, wobei sich die kollimierten Strahlen entlang eines Wegs fortpflanzen und einen kombinierten Strahl (24), der entlang des Wegs divergiert, definieren;
Fokussieren des divergierenden kombinierten Strahls (24) in eine Brennebene einer Sammellinse;
Lokalisieren eines Strahlempfangs-Kernendes einer Ausgangsfaser (30) in der Brennebene; und
Verschieben der einen Sammellinse um einen vorgegebenen Abstand von dem Strahlempfangs-Kernende der Ausgangsfaser (30) weg in der Weise, dass der kombinierte Strahl (24) in das Empfangskernende gekoppelt wird, wobei der fokussierte kombinierte Strahl (24) bei einem Eintritt in das Empfangskernende einen kleineren Querschnitt als der Querschnitt des kombinierten Strahls (24) in der Brennebene aufweist, **dadurch gekennzeichnet, dass** der vorgegebene Abstand bestimmt wird durch:

Lokalisieren der am wenigsten beabstandeten Querschnitte von jeweils zwei Ausgangsstrahlen (14) ausgangsseitig der einen Sammellinse (22), wobei die zwei Ausgangsstrahlen (14) durch jeweilige MM-Chips (12) emittiert werden, wobei einer der MM-Chips (12) der einer Sammellinse (22) am nächsten und der andere MM-Chip (12) am weitesten von ihr ist;
Bestimmen eines Abstands zwischen den lokalisierten kleinsten Querschnitten; und
Wählen des in dem vorhergehenden Schritt bestimmten Abstands als vorgegebenen Abstand, oder durch:

Lokalisieren kleinster Querschnitte der jeweiligen Ausgangsstrahlen (14) ausgangsseitig der eine Sammellinse (22);
Bestimmen eines Abstands als ein Mittelwert von Abständen zwischen der einen Sammellinse und jeweils lokalisierten Querschnitten; und
Wählen des in dem vorhergehenden Schritt bestimmten Abstands als vorgegebenen Abstand.

5. Verfahren nach Anspruch 4,
wobei die eine Sammellinse den divergierenden kombinierten Strahl (24) in einer langsamen Achse fokussiert.

6. Verfahren nach Anspruch 5, das ferner umfasst:

Kollimieren von Ausgangsstrahlen (14) jeweils in einer schnellen Achse durch einen Kollimator der schnellen Achse, FAC, (16), der sich einlassseitig des SAC (18) befindet; und
Fokussieren des divergierenden kombinierten Strahls (24) in der schnellen Achse durch die eine Sammellinse.

7. Verfahren nach Anspruch 6, das ferner umfasst:

Fokussieren des divergierenden kombinierten Strahls (24) in der schnellen Achse durch eine zweite Sammellinse, die sich zwischen den MM-Chips (12) und der einen Sammellinse befindet; selektives Einstellen einer Winkelposition selektiver Spiegel, die sich zwischen der zweiten Sammellinse und jeweiligen SACs (18) befinden, um eine Brennebene der einen Sammellinse (22) in einer schnellen Achse des kombinierten Strahls (24) in der Weise einzustellen, das sie mit dem einlassseitigen Kernende der Ausgangsfaser (30) koplanar ist.

8. Verfahren nach Anspruch 4, das ferner umfasst:

Kollimieren der Ausgangsstrahlen (14) in jeweiligen schnellen Achsen durch mehrere FACs (16), die sich jeweils einlassseitig des SAC (18) befinden; und
Fokussieren des divergierenden kombinierten Strahls (24) in der schnellen Achse durch eine zweite Sammellinse, die sich zwischen den MM-Chips (12) und der einen Sammellinse befindet.

## Revendications

1. Module laser à diode en queue de cochon (50), comprenant,

un boîtier (34) abritant des puces multimodes, MM, (12) espacées, émettant des faisceaux de sortie parallèles respectifs (14) le long d'une trajectoire ;

un système optique configuré pour collimater les faisceaux de sortie parallèles (14) en faisceaux collimatés dans des axes lents respectifs, les faisceaux collimatés définissant un faisceau combiné (24) qui diverge le long de la trajectoire, le système optique comprenant :

une pluralité de collimateurs à axe lent, SAC, (18), chacun étant situé entre la puce MM (12) et une lentille de focalisation configurée pour collimater le faisceau de sortie (14) dans l'axe lent, et couplé optiquement à cette puce ; et

une pluralité de collimateurs à axe rapide, FAC, (16), couplés entre les puces MM (12) et les SAC (18) respectifs, les puces MM (12) étant disposées sur au moins une rangée et émettant les faisceaux de sortie respectifs (14) dans une première direction ;

au moins une lentille de focalisation (22) pour focaliser le faisceau combiné (24) dans un plan focal de celle-ci ; et

une fibre de sortie (30) couplée au boîtier (34) et dont l'extrémité du noyau se trouve en aval du plan focal,

le faisceau combiné (24), couplé à l'extrémité du noyau, présentant une section transversale inférieure à celle du faisceau combiné (24) dans le plan focal, **caractérisé en ce que**

l'extrémité du noyau est espacée en aval du plan focal de la lentille de focalisation (22) à une distance correspondant à une différence entre les distances des plus petites sections transversales respectives des faisceaux de sortie (14), qui sont émis respectivement par la première et la dernière puce MM (12), lesdites plus petites sections transversales respectives étant situées en aval de la lentille de focalisation (22), la première puce MM (12) étant la plus proche de la lentille de focalisation (22), et la dernière puce MM (12) étant la plus éloignée de la lentille de focalisation (22) ;

ou, **en ce que**

l'extrémité du noyau est espacée en aval du plan focal de la lentille de focalisation (22) à une distance correspondant à une valeur moyenne des distances entre la lentille de focalisation (22) et les plus petites sections transversales respectives des faisceaux de sortie (14) qui sont situées en aval de la lentille de focalisation, les puces MM (12) étant espacées de la lentille de focalisation (22) à des distances respectives qui sont différentes les unes des autres.

2. Le module laser à diode en queue de cochon (50) selon la revendication 1,

dans lequel le système optique comprend en outre une pluralité de miroirs à réglage angulaire (20), chacun étant situé entre le SAC (18) et la lentille de focalisation (22) et déviant le faisceau de sortie collimaté dans une seconde direction transversale à la première direction, la lentille de focalisation (22) étant configurée pour focaliser le faisceau combiné (24) à la fois dans l'axe rapide et dans l'axe lent.

3. Le module laser à diode en queue de cochon (50) selon la revendication 1, comprenant en outre au moins une seconde lentille de focalisation espacée en amont de la première lentille de focalisation (22) et configurée pour focaliser le faisceau combiné (24) dans l'axe rapide.

4. Procédé de fabrication d'un module laser à diode en queue de cochon (50), comprenant :

l'alimentation d'une pluralité de puces MM (12), produisant ainsi des faisceaux parallèles respectifs (14) ;

la collimation des faisceaux de sortie parallèles (14), chacun dans un axe lent avec un collimateur à axe lent, SAC, couplé optiquement à la puce MM (12) et situé en aval de celle-ci, les faisceaux collimatés se propageant le long d'une trajectoire et définissant un faisceau combiné (24) divergeant le long de la trajectoire ;

la focalisation du faisceau combiné divergent (24) dans un plan focal d'une lentille de focalisation ;

la localisation d'une extrémité du noyau de réception de faisceau d'une fibre de sortie (30) dans le plan focal ;

et

l'éloignement de la lentille de focalisation de l'extrémité du noyau de réception de faisceau de la fibre de sortie (30) d'une distance prédéterminée de sorte que le faisceau combiné (24) soit couplé à l'extrémité du noyau de réception, le faisceau combiné focalisé (24) ayant une section transversale à une entrée de l'extrémité du noyau de réception plus petite que la section transversale du faisceau combiné (24) dans le plan focal, **caractérisé en ce que** la distance prédéterminée est déterminée par :

la localisation des plus petites sections transversales espacées de deux faisceaux de sortie respectifs (14) en aval de la lentille de focalisation (22), les deux faisceaux de sortie (14) étant émis par des puces MM (12) respectives, l'une des puces MM (12) étant la plus proche et l'autre puce MM (12) étant la plus éloignée de la lentille de focalisation (22) ;

la détermination d'une distance entre les plus petites sections transversales localisées ; et

le choix, comme distance prédéterminée, de la distance déterminée à l'étape précédente, ou par :

> la localisation des plus petites sections transversales des faisceaux de sortie respectifs (14) en aval de la lentille de focalisation (22) ;
>
> la détermination d'une distance en tant que valeur moyenne des distances entre la lentille de focalisation et les sections transversales localisées respectives ; et
>
> le choix, comme distance prédéterminée, de la distance déterminée à l'étape précédente.

5. Le procédé selon la revendication 4, dans lequel la lentille de focalisation focalise le faisceau combiné divergent (24) dans un axe lent.

6. Le procédé selon la revendication 5, comprenant en outre :

> la collimation des faisceaux de sortie (14), chacun dans un axe rapide par un collimateur d'axe rapide, FAC, (16) situé en amont du SAC (18) ; et
>
> la focalisation du faisceau combiné divergent (24) dans l'axe rapide par la lentille de focalisation.

7. Le procédé selon la revendication 6, comprenant en outre

> la focalisation du faisceau combiné divergent (24) dans l'axe rapide par une seconde lentille de focalisation située entre les puces MM (12) et la première lentille de focalisation ;
>
> l'ajustement sélectif d'une position angulaire de miroirs sélectifs situés entre la seconde lentille de focalisation et les SAC respectifs (18) pour ajuster un plan focal de la première lentille de focalisation (22) dans un axe rapide du faisceau combiné (24) afin qu'il soit coplanaire avec l'extrémité du noyau en amont de la fibre de sortie (30).

8. Le procédé selon la revendication 4, comprenant en outre :

la collimation des faisceaux de sortie (14) dans les axes rapides respectifs par une pluralité de FAC (16), chacun étant situé en amont du SAC (18) ; et

la focalisation du faisceau combiné divergent (24) dans l'axe rapide par une seconde lentille de focalisation située entre les puces MM (12) et la première lentille de focalisation.

FIG. 1
Known Art

FIG. 2
Known Art

FIG. 3

FIG. 4

FIG. 5

FIG. 6

FIG. 7

Slow Axis

Fast Axis

$14_n$  $14_1$

$14_1 \ldots 14n$

D

Minimal X-section

FIG. 8

FIG. 9

FIG. 10

**REFERENCES CITED IN THE DESCRIPTION**

**Patent documents cited in the description**

- US 7764723 B
- US 2015003484 A1
- US 2016079728 A1